# EUROPÄISCHE PATENTSCHRIFT

(11) **EP 2 023 705 B1**
(45) Veröffentlichungstag und Bekanntmachung des Hinweises auf die Patenterteilung: **10.08.2011**
(21) Anmeldenummer: 08011693.2
(22) Anmeldetag: 27.06.2008
(51) Int. Cl.: H01R 9/26, H05K 7/14

(54) **Adapterplatte, Steckfassung und Vorrichtung zur Verbindung einer elektronischen Steuerung mit ihren Anschlussleitungen**
Adapter board, connector mounting and device for connecting an electronic controller with its connecting circuits
Plaque d'adaptation, connecteur femelle et dispositif de liaison d'une commande électronique dotée de sa conduite de raccordement

(30) Priorität: 09.08.2007 DE 202007011112 U
(43) Veröffentlichungstag der Anmeldung: 11.02.2009
(73) Patentinhaber: MC Technology GmbH, 78176 Blumberg (DE)
(72) Erfinder: Borst, Joachim, 78166 Donaueschingen (DE)
(74) Vertreter: Patentanwälte Westphal, Mussgnug & Partner

(56) Entgegenhaltungen:
- DE-A1- 19 515 923
- DE-C1- 4 438 804
- DE-U1- 29 901 194
- GB-A- 2 035 716
- US-A1- 2002 038 981

## Beschreibung

Die Erfindung betrifft eine Vorrichtung zur Verbindung einer elektronischen Steuerung mit ihren Anschlussleitungen.

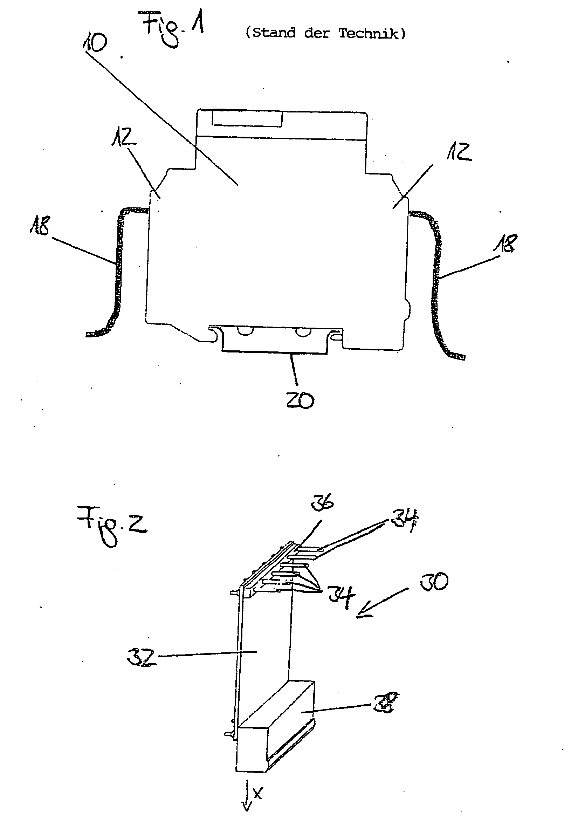

Elektronische Steuerungen oder Ein-/Ausgabebausteine, mit welchen bspw. verschiedenste Komponenten von Gebäuden, wie bspw. Türen, Jalousien, Heizungen oder Klimaanlagen, gesteuert werden, besitzen häufig Anschlüsse für den Anschluss externer Sensoren, Aktoren oder sonstiger Anschlussleitungen. Derartige Steuerungen sind somit insbesondere für den Anschluss von einzelnen Anschlussleitungen ausgelegt. Je nach Ausbildung der Steuerung können 4 bis 32, aber auch deutlich mehr Anschlussleitungen, wie bspw. 100 oder 200 Anschlussleitungen, an einer einzelnen Steuerung enden. Jede einzelne dieser Anschlussleitungen muss in dem vorgesehenen Anschluss, bspw. einer Anschlussklemme, einzeln befestigt werden. Eine derartige Steuerung 10 gemäß dem Stand der Technik zeigt auch Fig. 1, wobei die elektronische Steuerung 10 auf einer Hutschiene 20 aufgesetzt ist und Anschlussklemmen 12 aufweist, in denen Anschlussleitungen 18 befestigt sind.

Falls eine derartige Steuerung ausgetauscht werden soll, da sie entweder defekt ist, gewartet werden soll, oder gegen ein neues Gerät ausgetauscht werden soll, müssen sämtliche Anschlussleitungen einzeln entfernt und nach Wartung oder Austausch des Gerätes erneut wieder an die richtigen Anschlussklemmen angeschlossen werden. Einerseits ist die Gefahr der Verwechslung bei einem derartigen Austausch sehr groß, sodass ggf. auch nach dem Austausch Fehlfunktionen aufgrund vertauschter Anschlussleitungen vorliegen können. Der größte Nachteil besteht jedoch darin, dass das Anklemmen und Neuanschließen der Vielzahl der Anschlussleitungen extrem zeitaufwändig ist, wobei während dieser Arbeiten an der Steuerung die Steuerung vollständig außer Betrieb gesetzt werden muss, damit keine Gefahr für die benutzende Person besteht. Derartige Ausfallzeiten, die je nach Größe oder auch Anzahl der Steuerungen mehrere Stunden bis hin zu einigen Tagen betragen können, sind jedoch im laufenden Betrieb inakzeptabel.

Die Druckschrift DE 29 901 194 U1 beschreibt einen Busleiterabschnitt für ein elektrisches Gerät mit modularem Aufbau zur Steuerung und/oder Überwachung technischer Prozesse zur Industrie- oder Gebäudeautomatisierung mit wenigstens einem auf eine Tragschiene aufsetzbarem Anschlussmodul für externe Leiter und mit einer Reihung scheibenförmiger Basis-Klemmträger, wobei innerhalb jedes Anschlussmoduls der interne Busleiterabschnitt im Wesentlichen parallel zur Tragschiene verläuft.

Die Druckschrift DE 44 38 804 C1 betrifft eine modulare Steuerungsanlage für elektronische Steuerungssysteme z. B. zur Gebäudeautomatisierung, bei der auf Tragschienen anreihbare Anschlussblocks eine Signalanpassung und -verarbeitung zwischen parallel angeschlossenen Initiatoren, Aktoren, Feldgeräten oder dergleichen und einem internen seriellen Busleiter herstellen, der an ein übergeordnetes Feldbussystem ankoppelbar ist.

Die Druckschrift DE 195 15 932 A1 betrifft einen Sammelschienenadapter zur Halterung von elektrischen Installationsgeräten, der mit innen liegenden Kontaktschienen zur Stromabnahme von den Sammelschienen ausgerüstet ist. Der Adapter weist ein auf seine Oberseite aufsteckbares Steckmodul zur elektrischen Verbindung des Installationsgerätes und den Kontaktschienen auf. Das Steckmodul besitzt an seiner Unterseite Fußkontakte zum Einstecken in die Steckbuchsen an der Oberseite des Adapters und an seiner dem Installationsgerät zugewandten Frontseite Abgangs-Steckkontakte.

Die Aufgabe der Erfindung besteht darin, bei einer standardmäßigen, elektronischen Steuerung nachträglich eine Verbindung mit ihren Anschlussleitungen zu ermöglichen, welche einen zügigen Austausch einer Steuerung ermöglichen.

Die Aufgabe der Erfindung wird gelöst durch eine Vorrichtung zur Verbindung einer elektronischen Steuerung mit ihrem Anschlussleitungen gemäß Schutzanspruch 1.

Vorteilhafte Ausgestaltungen und Weiterbildungen der Erfindung sind in den Unteransprüchen angegeben.

Eine Adapterplatte der erfindungsgemäßen Vorrichtung zur Verbindung einer elektronischen Steuerung mit ihren Anschlussleitungen weist eine Leiterplatte mit wenigstens zwei Stiften und mit einem Steckverbinder auf. Die Stifte sind in die Anschlüsse für die Anschlussleitungen der elektronischen Steuerung einführbar, während der Steckverbinder in einen Gegenstecker einer Steckfassung, die in Signalverbindung mit den Anschlussleitungen bringbar ist, einsteckbar ist. Über die Leiterplatte sind die Stifte mit dem Steckverbinder elektrisch leitend verbunden. Wesentlicher Gedanke der Erfindung ist, die elektronische Steuerung derart auszustatten, dass sie steckbar wird, sodass durch einfaches Lösen der Steckverbindung mit dem Gegenstecker ein schneller Austausch der elektronischen Steuerung ermöglicht wird, ohne zum Austauschen sämtliche Anschlussleitungen lösen und wieder neu anschließen zu müssen. Dadurch, dass die Anschlussleitungen nicht direkt in der Steuerung, sondern in einer Steckfassung angeschlossen werden, und dadurch, dass in die Anschlüsse der elektronischen Steuerung, in die gemäß dem Stand der Technik die Anschlussleitungen direkt angeschlossen werden, nun die Stifte der Adapterplatte eingebracht werden, wird die Steuerung derart ausgerüstet, dass zum erneuten Austausch der Steuerung lediglich die Steckverbindung aus dem Gegenstecker der Steckfassung gelöst werden muss und anschließend in extrem kurzer Zeit ein neues Gerät über den Steckverbinder wieder in die Steckfassung eingesetzt werden kann. Die Austauschzeit für die elektronische Steuerung, während der die Steuerung außer Betrieb gesetzt werden muss, ist somit lediglich ein Bruchteil der Austauschzeit, die gemäß dem Stand der Technik benötigt wird, um sämtliche Anschlussleitungen aus der Steuerung zu entfernen und nach Wartung des Gerätes oder an einem neuen Gerät wieder neu anzuschließen.

Vorzugsweise sind die Stifte im Wesentlichen senkrecht zur Leiterplatte angeordnet, sodass die Leiterplatte im Wesentlichen parallel zur Außenseite des Gehäuses der elektronischen Steuerung verläuft und dadurch die äußeren Dimensionen der elektronischen Steuerung nicht wesentlich vergrößert werden.

Bei einer besonders bevorzugten Ausführungsform der Erfindung sind die Stifte in einer Stiftleiste, vorzugsweise einer gelöteten Stiftleiste, angeordnet, sodass ihre relative Lage zueinander festgelegt ist und die Stifte zudem einfach und kostengünstig herzustellen sind.

Besonders bevorzugt weist der Steckverbinder eine Steckrichtung auf, welche parallel zur Fläche der Leiterplatte verläuft, da bei Anbringen der Adapterplatte im Wesentlichen parallel zur Außenseite des Gehäuses der elektronischen Steuerung diese Steuerung somit den Steckverbinder im Wesentlichen im Bereich der Bodenplatte des Gehäuses aufweist und damit die elektronische Steuerung im Wesentlichen senkrecht von oben auf den entsprechenden Gegenstecker aufgesetzt werden kann.

Besonders bevorzugt weist die Adapterplatte ein Schutzgehäuse auf, welches insbesondere isolierend ausgebildet ist, sodass es einen Schutz gegen Berührung der leitenden Teile, insbesondere der Leiterbahnen der Leiterplatte sowie den Kontakten zwischen den Stiften und den Leiterbahnen sowie den Leiterbahnen und dem Steckverbinder bildet.

Eine Steckfassung der erfindungsgemäßen Vorrichtung zur Verbindung einer elektronischen Steuerung mit ihren Anschlussleitungen weist einerseits einen Gegenstecker auf, in welchen die elektronische Steuerung über einen Steckverbinder einsteckbar ist, und weist andererseits Anschlüsse für die Anschlussleitungen der elektronischen Steuerung auf, sodass die Anschlussleitungen nicht direkt in die elektronische Steuerung, sondern in die Steckfassung angeschlossen werden. Die Anschlüsse stehen mit dem Gegenstecker in elektrisch leitender Verbindung. Bei Austausch der elektronischen Steuerung müssen somit nicht die Anschlussleitungen von der elektronischen Steuerung entfernt und nach Wartung oder Austausch des Gerätes neu an die Steuerung wieder angeschlossen werden, sondern es muss lediglich die Verbindung zwischen dem Steckverbinder und dem Gegenstecker gelöst werden, um ein einfaches, sicheres und insbesondere schnelles Austauschen der elektronischen Steuerung zu ermöglichen. Der Steckverbinder kann dabei direkt an der Steuerung bzw. ihrem Gehäuse angeordnet sein oder auch über die erfindungsgemäße Adapterplatte an der Steuerung angeordnet sein.

Vorzugsweise ist die Steckfassung auf einer Hutschiene montierbar. Gemäß dem Stand der Technik wird in der Regel die elektronische Steuerung direkt auf der Hutschiene montiert, sodass durch die erfindungsgemäße Montage der Steckfassung auf der Hutschiene und der Möglichkeit, die elektronische Steuerung auf die Steckfassung aufzustecken, weiterhin ein möglichst kompakter Aufbau ermöglicht wird.

Die erfindungsgemäße Vorrichtung zur Verbindung einer elektronischen Steuerung mit ihren Anschlussleitungen weist eine Adapterplatte sowie eine Steckfassung auf, um damit insgesamt ein Nachrüsten der bekannten elektronischen Steuerungen derart zu ermöglichen, dass ein schneller Austausch der elektronischen Steuerungen ermöglicht wird.

Die Erfindung wird anhand der folgenden Figuren ausführlich erläutert.

Es zeigt:
- Fig. 1: eine schematische Darstellung einer Steuerung gemäß dem Stand der Technik,
- Fig. 2: eine perspektivische Darstellung einer Adapterplatte,
- Fig. 3: eine perspektivische Darstellung einer elektronischen Steuerung gemäß dem Stand der Technik, welche mit zwei Adapterplatten gemäß Fig. 2 ausgerüstet wird,
- Fig. 4: eine Seitenansicht der erfindungsgemäßen Vorrichtung zur Verbindung einer elektronischen Steuerung mit ihren Anschlussleitungen und
- Fig. 5: ein weiteres Ausführungsbeispiel einer Adapterplatte.

Gleiche Teile in den Figuren sind mit gleichen Bezugsziffern bezeichnet.

Fig. 2 zeigt eine perspektivische Ansicht einer Adapterplatte 30, welche eine im Wesentlichen rechteckige Leiterplatte 32 aufweist, an deren einer Längskante eine Stiftleiste 36 mit mehreren parallel zueinander verlaufenden Stiften 34 angeordnet ist. Die Stifte 34 stehen dabei im Wesentlichen senkrecht zur Leiterplatte 32 und sind in Durchlochtechnik mit nicht dargestellten Leiterbahnen der Leiterplatte 32 verbunden. An der gegenüberliegenden Längskante der Leiterplatte 32 ist ein Steckverbinder 38 angeordnet, wobei jeder der Stifte 34 über die Leiterbahnen der Leiterplatte 32 elektrisch leitend mit einem entsprechenden Kontakt des Steckverbinders 38 verbunden ist.

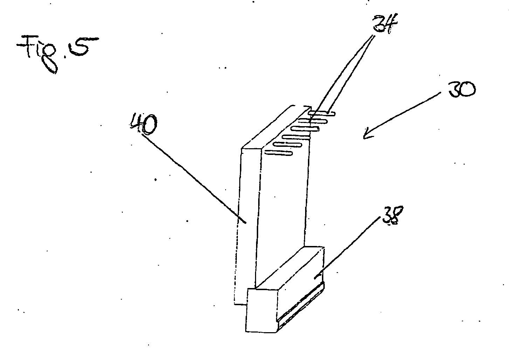

Fig. 5 zeigt eine alternative Ausführungsform der Adapterplatte 30, welche sich von der in Fig. 2 dargestellten Adapterplatte 30 lediglich dadurch unterscheidet, dass über der Leiterplatte 32 ein Schutzgehäuse 40 angeordnet ist, welches die Kontaktstellen zwischen den Stiften 34 und der Leiterplatte 32 bzw. dem Steckverbinder 38 und der Leiterplatte 32 abdeckt, sodass ein Schutz gegen Berührung von elektrisch leitenden Teilen besteht.

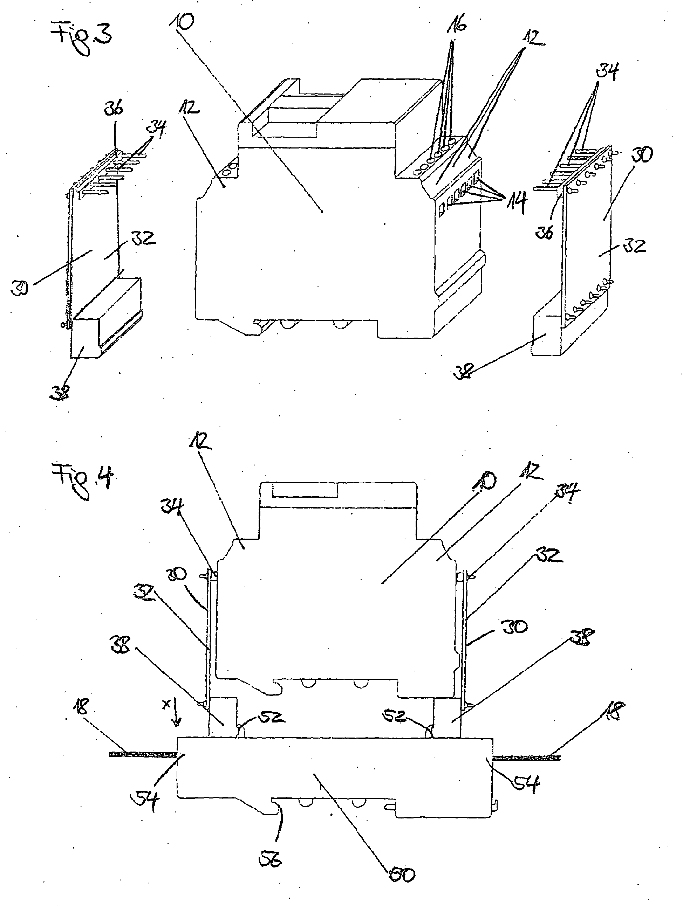

Fig. 3 zeigt die Nachrüstung der elektronischen Steuerung 10 gemäß dem Stand der Technik mit zwei Adapterplatten 30 gemäß Fig. 2. Die Steuerung 10 weist mehrere Anschlussklemmen 12 auf, welche in zwei gegenüberliegenden Reihen parallel nebeneinander angeordnet sind, sodass sich auf zwei Seiten des Gehäuses der elektronischen Steuerung 10 jeweils eine Reihe von Einschuböffnungen 14 ergibt, in die gemäß dem Stand der Technik die Anschlussleitungen 18 wie in Fig. 1 dargestellt direkt eingeführt und mit Hilfe von Klemmschrauben 16 festgeklemmt werden. Gemäß der Erfindung werden nun nicht die Anschlussleitungen 18, sondern die Stifte 34 der Adapterplatte 30 in die Einschuböffnungen 14 der Anschlussklemmen 12 der elektronischen Steuerung 10 eingeschoben und die Stifte 34 über die Klemmschrauben 16 in den Anschlussklemmen 12 fixiert. Vorzugsweise entspricht dabei die Anzahl der Stifte 34 einer der Leiterplatten 32 der Anzahl der Einschuböffnungen 14 auf einer Seite des Gehäuses der elektronischen Steuerung 10.

Die Länge der Leiterplatte 32 der Adapterplatte 30 ist so dimensioniert, dass die Leiterplatten 32 im Wesentlichen parallel zu den Seitenflächen des Gehäuses der Steuerung 10 verlaufen und die Steckverbinder 38 unterhalb der Bodenplatte des Gehäuses der Steuerung 10 zu liegen kommen. Dadurch wird es ermöglicht, die mit den beiden Adapterplatten 30 nachgerüstete Steuerung 10 in Steckrichtung x auf die Steckfassung 50 aufzustecken.

Wie in Fig. 4 dargestellt, wird die Steuerung 10 mit den beiden Adapterplatten 30 über die beiden Steckverbinder 38 auf eine Steckfassung 50 derart aufgesteckt, dass die Steckverbinder 38 in Kontakt mit zwei an der Steckfassung 50 angeordneten Gegensteckern 52 treten. Dadurch wird eine elektrisch leitende Verbindung zwischen den Steckverbindern 38 und der Steckfassung 50 und somit zwischen der Steckfassung 50 und den Anschlussklemmen 12 der Steuerung 10 hergestellt.

Die Steckfassung 50 weist ihrerseits nicht näher dargestellte Anschlüsse 54 für die Anschlussleitungen 18 der elektronischen Steuerung 10 auf, wobei bspw. die Anschlüsse 54 im Wesentlichen identisch zu den Anschlussklemmen 12 der elektrischen Steuerung 10 ausgebildet sein können. Insbesondere weist die Steckfassung 50 so viele Anschlüsse 54 auf, dass jede der Anschlussleitungen 18, die ansonsten in eine der Anschlussklemmen 12 der elektrischen Steuerung 10 angeschlossen wird, in die Steckfassung 50 angeschlossen werden kann. In der Steckfassung 50 besteht eine elektrisch leitende Verbindung zwischen den Anschlüssen 54 für die Anschlussleitungen 18 und dem Gegenstecker 52. Über die Adapterplatte 30 und die Steckfassung 50 wird somit eine elektrisch leitende Verbindung jeder einzelnen der Anschlussleitungen 18 über die Verbindung zwischen Gegenstecker 52 und dem Steckverbinder 38 über die Leiterbahnen der Leiterplatte 32 und die Stifte 34 mit der zu der jeweiligen Anschlussleitung 18 gehörenden Anschlussklemme 12 der elektrischen Steuerung 10 hergestellt. Die Steckfassung 50 kann insbesondere über einen Kontakt 56 auf der Hutschiene 20 montiert werden.

Wurde ein System gemäß dem Stand der Technik wie in Fig. 1 dargestellt derart nachgerüstet, dass sich ein System wie in Fig. 4 dargestellt ergibt, ist anschließend ein Austausch der elektronischen Steuerung 10 denkbar einfach und vor allen Dingen extrem zügig durchzuführen, indem lediglich die Verbindung zwischen den beiden Steckverbindern 38 und den Gegensteckern 52 der Steckfassung 50 gelöst werden muss und ein entsprechend mit zwei Adapterplatten 30 ausgerüstetes weiteres Gerät auf die Steckfassung 50 wieder aufgesetzt wird. Sollte die neu eingesteckte elektronische Steuerung 10 nicht sofort funktionstüchtig sein, kann sie innerhalb kürzester Zeit erneut abgezogen und durch die zuvor noch funktionierende Steuerung 10 ersetzt werden, um anschließend während eines laufenden Betriebes die fehlerhafte Steuerung 10 zu warten. Bei dem Austausch der elektronischen Steuerung 10 bleibt die Verdrahtung der Anschlussleitungen 18 unberührt, sodass weder ein versehentliches Vertauschen zweier Anschlussleitungen 18 erfolgen kann noch ein großer Zeitverlust durch Abklemmen und Neuanschließen jeder einzelnen der Anschlussleitungen 18 vonnöten ist.

### Bezugszeichenliste

- 10: Steuerung
- 12: Anschlussklemme
- 14: Einschuböffnung
- 16: Klemmschraube
- 18: Anschlussleitung

- 20: Hutschiene

- 30: Adapterplatte
- 32: Leiterplatte
- 34: Stift
- 36: Stiftleiste
- 38: Steckverbinder

- 40: Schutzgehäuse

- 50: Steckfassung
- 52: Gegenstecker
- 54: Anschluss
- 56: Kontakt

- x: Steckrichtung

## Patentansprüche

1. Vorrichtung zur Verbindung seitlicher Anschlussklemmen (12) einer elektronischen Steuerung (10), mit der beispielsweise Komponenten von Gebäuden gesteuert werden, mit Anschlussleitungen für Sensoren, Aktoren oder sonstigen Anschlussleitungen (18); die Vorrichtung umfasst:
- mindestens eine Adapterplatte (30), die eine Leiterplatte (32) mit wenigstens zwei Stiften (34) und mit einem Steckverbinder (38) umfasst und
- eine Steckfassung (50), die Klemmanschlüsse für die Anschlussleitungen (18) der elektronischen Steuerung (10) sowie einen Gegenstecker (52) zum Steckverbinder (38) der Adapterplatte (30) umfasst,
**dadurch gekennzeichnet,**
**dass** in verbundenem Zustand die Stifte (34) der Adapterplatte (30) in die seitlichen Anschlussklemmen (12) der elektronischen Steuerung (10) eingeschoben sind, der Steckverbinder (38) der Adapterplatte (30) mit dem Gegenstecker (52) der Steckfassung (50) zusammengesteckt ist und die Anschlussleitungen (18) an den Klemmanschlüssen der Steckfassung (50) angeschlossen sind, wodurch über die Adapterplatte (30) eine elektrische Verbindung zwischen den Anschlussleitungen (18) und der elektronischen Steuerung (10) hergestellt wird.

2. Vorrichtung nach Anspruch 1 mit einer Adapterplatte (30), bei der die Stifte (34) senkrecht zur Leiterplatte (32) angeordnet sind.

3. Vorrichtung nach einem der vorhergehenden Ansprüche mit einer Adapterplatte (30), bei der die Stifte (34) in einer Stiftleiste (36), vorzugsweise einer gelöteten Stiftleiste (36), angeordnet sind.

4. Vorrichtung nach einem der vorhergehenden Ansprüche mit einer Adapterplatte (30), bei der der Steckverbinder (38) eine Steckrichtung (x) aufweist, welche parallel zur Fläche der Leiterplatte (32) verläuft.

5. Vorrichtung nach einem der vorhergehenden Ansprüche,
**dadurch gekennzeichnet, dass** die Adapterplatte (30) ein Schutzgehäuse (40) aufweist.

6. Vorrichtung nach Anspruch 1,
**dadurch gekennzeichnet, dass** die Steckfassung (50) auf einer Hutschiene (20) montierbar ist.

## Claims

1. Device for connecting lateral terminals (12) of an electronic controller (10), by means of which for example components of buildings are controlled, to connecting lines for sensors, actuators or other such connecting lines (18); the apparatus comprises:
- at least one adapter board (30) which comprises a printed circuit board (32) having at least two pins (34) and having a plug-in connector (38), and
- a connector mounting (50) which comprises terminals for the connecting lines (18) of the electronic controller (10) and also a mating plug (52) for the plug-in connector (38) of the adapter board (30),
**characterised in that**, in the connected state, the pins (34) of the adapter board (30) are pushed into the lateral terminals (12) of the electronic controller (10), the plug-in connector (38) of the adapter board (30) is plugged together with the mating plug (52) of the connector mounting (50), and the connecting lines (18) are connected to the terminals of the connector mounting (50), as a result of which, via the adapter board (30), an electrical connection is established between the connecting lines (18) and the electronic controller (10).

2. Device according to claim 1, comprising an adapter board (30) in which the pins (34) are arranged perpendicular to the printed circuit board (32).

3. Device according to one of the preceding claims, comprising an adapter board (30) in which the pins (34) are arranged in a pin header (36), preferably a pin header (36) attached by soldering.

4. Device according to one of the preceding claims, comprising an adapter board (30) in which the plug-in connector (38) has a plug-in direction (x) that runs parallel to the surface of the printed circuit board (32).

5. Device according to one of the preceding claims, **characterised in that** the adapter board (30) has a protective housing (40).

6. Device according to claim 1, **characterised in that** the connector mounting (50) can be mounted on a top hat rail (20).

## Revendications

1. Dispositif pour relier des bornes latérales de branchement (12) d'un module de commande électronique (10) par exemple pour commander les composants de constructions, comprenant des lignes de branchement pour des capteurs, des actionneurs et autres lignes de branchement (18),
dispositif comprenant :
- au moins une plaque adaptatrice (30) comprenant une plaque de circuit (32) ayant au moins deux broches (34) et au moins un connecteur (38), et
- un support d'enfichage (50) comportant les bornes de branchement pour les lignes de branchement (18) du module de commande électronique (10), ainsi qu'un connecteur complémentaire (52) vers le connecteur (38) de la plaque adaptatrice (30),
dispositif **caractérisé en ce qu'**
à l'état relié, les broches (34) de la plaque adaptatrice (30) sont glissées dans les bornes latérales de branchement (12) du module de commande électronique (10), le connecteur (38) de la plaque adaptatrice (30) est relié au connecteur complémentaire (52) du support d'enfichage (50) et les lignes de branchement (18) sont reliées aux bornes du support d'enfichage (50) de façon que la plaque adaptatrice (30) réalise la liaison électrique entre les lignes de branchement (18) et le module de commande électronique (10).

2. Dispositif selon la revendication 1,
**caractérisé en ce qu'**
il comporte une plaque adaptatrice (30) dont les broches (34) sont perpendiculaires à la plaque de circuit (32).

3. Dispositif selon l'une des revendications précédentes,
**caractérisé par**
une plaque adaptatrice (30) dont les broches (34) sont installées dans une barrette porte-broches (36), de préférence une barrette de broches soudées (36).

4. Dispositif selon l'une des revendications précédentes,
**caractérisé par**
une plaque adaptatrice (30) dont le connecteur (38) a une direction d'enfichage (x) parallèle à la surface de la plaque de circuit (32).

5. Dispositif selon l'une des revendications précédentes,
**caractérisé en ce que**
la plaque adaptatrice (30) comporte un boîtier protecteur (40).

6. Dispositif selon la revendication 1,
**caractérisé en ce que**
le support d'enfichage (50) se monte dans un rail oméga (20).
